# EUROPÄISCHE PATENTANMELDUNG

(11) **EP 1 372 247 A1**
(43) Veröffentlichungstag der Anmeldung: **17.12.2003**
(21) Anmeldenummer: 02405492.6
(22) Anmeldetag: 14.06.2002
(51) Int. Cl.: H02K 11/04

(54) **Rotierende elektrische Maschine**

(71) Anmelder: ABB Research Ltd., 8050 Zürich (CH)
(72) Erfinder: Matthias, Berth, 8002 Z-rich (CH); Niayesh, Kaveh, 5430 Wettingen (CH)
(74) Vertreter: ABB Patent Attorneys

(57) **Zusammenfassung**

Es wird eine rotierende elektrische Maschine mit einem Rotor (1) und einem ein Blechpaket (3) aufweisenden Stator (2) angegeben, welches Blechpaket (3) von Wicklungsleitern (4) im wesentlichen axial bezüglich einer Rotorachse (5) durchzogen ist, wobei die Wicklungsleiter (4) im Bereich von Stirnflächen (10, 11) des Blechpakets (3) zu ersten Wicklungsschleifen (6) und zweiten Wicklungsschleifen (7) verbunden sind. Desweiteren ist ein Stromrichter (8) vorgesehen, der mit den Wicklungsschleifen (6, 7) verbunden ist, wobei der Stromrichter (8) aus Teilstromrichtern (9) mit jeweils mindestens einem ansteuerbaren Schaltelement (12) gebildet ist und die Teilstromrichter (9) mit dem Blechpaket (3) thermisch kontaktiert sind.

## Beschreibung

### Technisches Gebiet

Die Erfindung bezieht sich auf das Gebiet der elektrischen Maschinen. Sie geht aus von einer rotierenden elektrischen Maschine gemäss dem Oberbegriff des unabhängigen Anspruchs.

### Stand der Technik

Rotierende elektrische Maschinen, insbesondere Asynchronmaschinen weisen üblicherweise einen Rotor und einen Stator auf, wobei der Rotor und der Stator jeweils ein Blechpaket umfassen. Die Blechpakete sind gängigerweise von Wicklungsleitern einer Rotorwicklung beziehungsweise einer Statorwicklung, insbesondere in Form von Stäben, die in Nuten eingebracht sind, im wesentlichen axial bezüglich einer Rotorachse durchzogen. Desweiteren sind die an den Stirnflächen des Blechpakets des Stators austretenden Wicklungsleiter im Bereich der Stirnflächen miteinander verbunden und bilden erste und zweite Wicklungsschleifen. Gespeist werden die Wicklungsschleifen der Statorwicklung von einem Stromrichter, der im Gehäuse der elektrischen Maschine untergebracht ist, wobei das Gehäuse den Stator umschliesst. Eine solche rotierende elektrische Maschine ist beispielsweise in "IMD Integrated Motor Drives, TB Wood's Incorporated Pennsylvania, IMD 6/99-10M" angegeben. Darin ist der Stromrichter an der Innenseite des Gehäuses der elektrischen Maschine angeordnet und befestigt und erstreckt sich in Umfangsrichtung um das Blechpaket des Stators. Darüber hinaus ist im Bereich einer Stirnfläche des Blechpakets des Stators ein Kühlungsventilator angebracht, der die entsprechende Stirnfläche mit Kühlluft anströmt.

Problematisch bei einer vorstehend beschriebenen rotierenden elektrischen Maschine mit integriertem Stromrichter ist, dass vom Stromrichter erzeugte Verlustwärme abgeführt werden muss, damit keine zu hohe thermische Belastung und somit eine Schädigung oder gar Zerstörung des Stromrichters und der Statorwicklung auftritt. Eine solche Abführung der Verlustwärme des Stromrichters ist jedoch nur über das Gehäuse der rotierenden elektrischen Maschine möglich, da der Stromrichter von anströmender Kühlluft des Kühlungsventilators nicht oder zumindest nicht ausreichend erreicht wird. Demnach muss der Stromrichter durch entsprechend aufwendige Ausführungen des Gehäuses der rotierenden elektrischen Maschine und/oder durch eine aufwendige zusätzliche Kühlungseinrichtung gekühlt werden. Solche Massnahmen zur Kühlung des Stromrichters sind jedoch material- und damit kostenintensiv und benötigen viel Platz. Weiterer Platzbedarf entsteht bei einer vorstehend beschriebenen rotierenden elektrischen Maschine dann, wenn die rotierende elektrische Maschine für grosse Leistungen ausgelegt werden soll. Der Stromrichter muss dann nämlich für dieses grossen Leistungen ausgelegt und dimensioniert werden, wodurch der sich in Umfangsrichtung um das Blechpaket des Stators erstreckende Stromrichter eine Platzausdehnung der rotierenden elektrischen Maschine in radialer Richtung bezüglich der Rotorachse bewirkt. Eine bezüglich ihres Umfangs und Durchmessers kleine rotierende elektrische Maschine ist somit mit einem derart angeordneten Stromrichter nicht realisierbar.

### Darstellung der Erfindung

Aufgabe der Erfindung ist es deshalb, eine rotierende elektrische Maschine derart weiterzubilden, dass eine verbesserte Kühlung eines Stromrichters der rotierenden elektrischen Maschine bei gleichzeitig geringer Baugrösse der rotierenden elektrischen Maschine ermöglicht werden kann. Diese Aufgabe wird durch die Merkmale des Anspruchs 1 gelöst. In den Unteransprüchen sind vorteilhafte Weiterbildungen der Erfindung angegeben.

Die erfindungsgemässe rotierende elektrische Maschine umfasst einen Rotor und einen ein Blechpaket aufweisenden Stator, wobei das Blechpaket des Stators von Wicklungsleitern im wesentlichen axial bezüglich einer Rotorachse des Rotors durchzogen ist. Die Wicklungsleiter sind im Bereich von Stirnflächen des Blechpakets zu ersten Wicklungsschleifen und zweiten Wicklungsschleifen verbunden. Darüber hinaus ist ein Stromrichter der rotierenden elektrischen Maschine vorgesehen, der mit den Wicklungsschleifen verbunden ist. Erfindungsgemäss ist der Stromrichter aus Teilstromrichtern mit jeweils mindestens einem ansteuerbaren Schaltelement gebildet, wobei die Teilstromrichter mit dem Blechpaket thermisch kontaktiert sind.

Durch die Aufteilung des Stromrichters in Teilstromrichter und die thermische Kontaktierung der Teilstromrichter mit dem Blechpaket des Stators kann vorteilhaft die Kühlwirkung des Blechpakets für den Stromrichter ausgenutzt werden, wobei das Blechpaket beispielsweise durch einen Kühlluftstrom, insbesondere erzeugt durch einen Kühlungsventilator, angeströmt und somit gekühlt wird. Eine separate Kühlungseinrichtung für den Stromrichter und/oder eine aufwendige Ausführung der rotierenden elektrischen Maschine beispielsweise durch eine vergrösserte Gehäuseoberfläche der rotierenden elektrischen Maschine kann vorteilhaft entfallen. Die erfindungsgemässe rotierende elektrische Maschine zeichnet sich somit durch eine kombinierte Kühlung von Blechpaket und Stromrichter aus, wobei die Aufteilung des Stromrichters in Teilstromrichter zum einem zu einer weiteren Verbesserung der Kühlung des Stromrichters beiträgt und zum anderen eine geringe Baugrösse der rotierenden elektrischen Maschine durch die Möglichkeit einer nahezu beliebigen Anordnung der Teilstromrichter auf dem Blechpaket bewirkt.

Diese und weitere Aufgaben, Vorteile und Merkmale der vorliegenden Erfindung werden aus der nachfolgenden detaillierten Beschreibung bevorzugter Ausführungsbeispiele der Erfindung in Verbindung mit der Zeichnung offensichtlich.

### Kurze Beschreibung der Zeichnung

Es zeigen:
- Fig. 1a: eine erste Ausführungsform einer erfindungsgemässen rotierenden elektrischen Maschine in der Vorderansicht,
- Fig. 1b: eine Seitenansicht der ersten Ausführungsform der rotierenden elektrischen Maschine gemäss Fig. 1a,
- Fig. 2: eine Darstellung in einer Ebene einer ersten Ausführungsform einer Wicklungsleiterverschaltung der erfindungsgemässen rotierenden elektrischen Maschine,
- Fig. 3: eine Darstellung in einer Ebene einer zweiten Ausführungsform einer Wicklungsleiterverschaltung der erfindungsgemässen rotierenden elektrischen Maschine und
- Fig. 4: eine Gesamtschaltung der erfindungsgemässen rotierenden elektrischen Maschine mit der zweiten Ausführungsform der Wicklungsleiterverschaltung gemäss Fig. 3.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

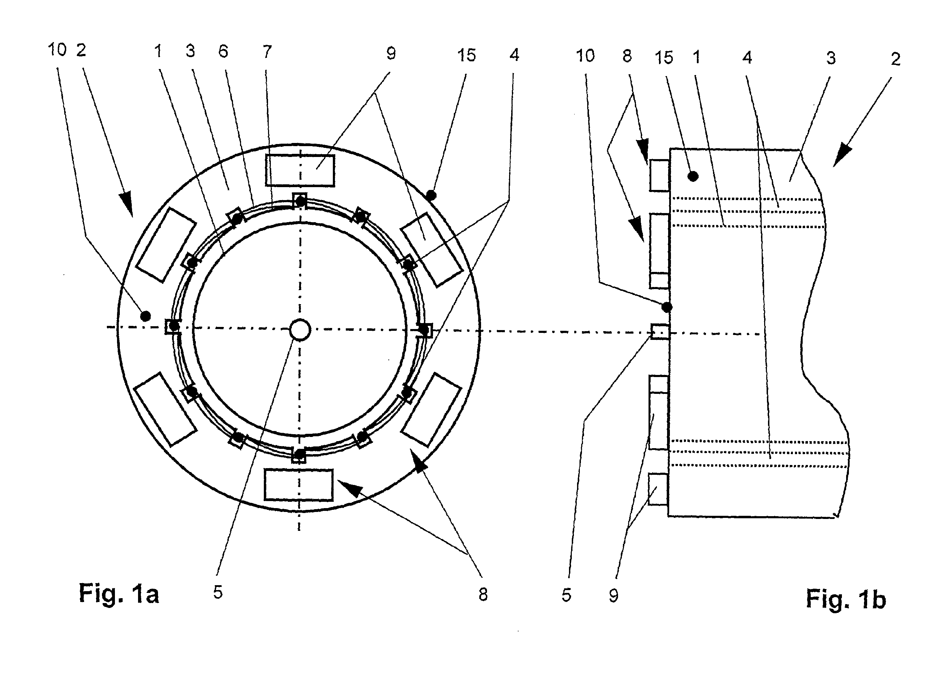

In Fig. 1a ist eine erste Ausführungsform einer erfindungsgemässen rotierenden elektrischen Maschine in der Vorderansicht und in Fig. 1b in der Seitenansicht gezeigt. Die rotierende elektrische Maschine weist darin einen Rotor 1 und einen ein Blechpaket 3 aufweisenden Stator 2 auf, wobei das Blechpaket 3 von Wicklungsleitern 4 im wesentlichen axial bezüglich einer Rotorachse 5 des Rotors 1 durchzogen ist. Die Wicklungsleiter 4 sind im Bereich von Stirnflächen 10, 11 des Blechpakets 3 zu ersten Wicklungsschleifen 6 und zweiten Wicklungsschleifen 7 verbunden. In Fig. 1a und Fig. 1b ist eine erste Stirnfläche 10 dargestellt, wobei das Blechpaket 3 der erfindungsgemässen rotierenden elektrischen Maschine in der ersten Ausführungsform gemäss Fig. 1 und Fig. 1b eine zweite, der Übersichtlichkeit halber nicht dargestellte zweite Stirnfläche 11 aufweist, welche, wie die erste Stirnfläche 10, einen Abschluss des Blechpakets 3 in axialer Richtung bezüglich der Rotorachse 5 bildet und der ersten Stirnfläche 10 gegenüber liegt. Ausführungsformen des Blechpakets 3 sind jedoch keineswegs auf nur eine erste und eine zweite Stirnfläche 10, 11 beschränkt, sondern können eine Vielzahl an Stirnflächen aufweisen. Ferner weist das Blechpaket 3 gemäss Fig. 1a und Fig. 1b eine sich in axialer Richtung bezüglich der Rotorachse 5 erstreckenden Mantelfläche 15 auf. Desweiteren weist die rotierende elektrische Maschine einen Stromrichter 8 auf, d.h. der Stromrichter 8 ist in die rotierende elektrische Maschine integriert und ist mit den ersten und zweiten Wicklungsschleifen 6, 7 verbunden.

Erfindungsgemäss ist der Stromrichter 8 aus Teilstromrichtern 9 mit jeweils mindestens einem ansteuerbaren Schaltelement 12 gebildet, wobei die Teilstromrichter 9 mit dem Blechpaket 3 thermisch kontaktiert sind. Die Aufteilung des Stromrichters 8 in Teilstromrichter 9 sowie die thermische Kontaktierung der Teilstromrichter 9 mit dem Blechpaket 3 des Stators 2 bewirkt eine verbesserte Kühlung des Stromrichters 9 durch einen Kühlluftstrom, insbesondere erzeugt durch einen gängigen Kühlungsventilator, da der Stromrichter 8 durch die Aufteilung in Teilstromrichter 9 eine grössere Oberfläche aufweist und zusätzlich vom Blechpaket 3 mitgekühlt wird. Auf eine separate Kühlungseinrichtung für den Stromrichter 8 und/oder eine aufwendige Ausführung der rotierenden elektrischen Maschine, beispielsweise durch eine vergrösserte Gehäuseoberfläche der rotierenden elektrischen Maschine, kann vorteilhaft verzichtet werden. Desweiteren kann durch die Aufteilung des Stromrichters 8 in Teilstromrichter 9 eine geringe Baugrösse der rotierenden elektrischen Maschine erzielt werden, da die Aufteilung die Möglichkeit einer nahezu beliebigen Anordnung der Teilstromrichter 9 auf dem Blechpaket 3 zulässt.

Eine weitere Verringerung der Baugrösse der rotierenden elektrischen Maschine, insbesondere bezüglich des Umfangs und Durchmessers der rotierenden elektrischen Maschine, kann dadurch erreicht werden, dass die Teilstromrichter 9, wie in Fig. 1a und Fig. 1b gezeigt, im Bereich mindestens einer Stirnfläche 10, 11 des Blechpakets 3 angeordnet sind. Durch die Anordnung der Teilstromrichter 9 beispielsweise an der ersten Stirnfläche 10 und an der zweiten Stirnfläche 11 kann weiterhin eine homogenere Wärmeverteilung bezüglich des Blechpakets 3 erreicht werden, so dass lokale Bereiche mit einer hohen Wärmedichte auf dem Blechpaket 3 vermieden werden können. Da, wie vorstehend erwähnt, der Stromrichter 8 mit den ersten und zweiten Wicklungsschleifen 6, 7 verbunden ist, sind auch die Teilstromrichter 9 mit den ersten und zweiten Wicklungsschleifen 6, 7 verbunden, so dass mit der Anordnung der Teilstromrichter 9 beispielsweise an der ersten Stirnfläche 10 und an der zweiten Stirnfläche 11 zudem sehr kurze Verbindungen zwischen den Teilstromrichtern 9 und den entsprechenden Wicklungsschleifen 6, 7 entstehen. Dadurch wird ein extrem störungsarmer Aufbau der rotierenden elektrischen Maschine erzielt, da in solche kurze Verbindungen annähernd keine Störwellen von aussen aus der Umgebung einkoppeln können. Ferner können auch aus diesen kurzen Verbindungen im wesentlichen keine Störwellen aus der rotierenden elektrischen Maschine an die Umgebung auskoppeln. Weiterhin kann mittels der erreichten kurzen Verbindungen zwischen den Teilstromrichtern 9 und den entsprechenden Wicklungsschleifen 6, 7 vorteilhaft Material und Gewicht eingespart werden und eine aufwendige Verbindungsverkabelung vermieden werden. Vorzugsweise sind die Teilstromrichter 9 an der entsprechenden Stirnfläche 10, 11 ringförmig angeordnet, wobei eine solche ringförmige Anordnung vorteilhaft zu einer weiteren Verbesserung der Homogenisierung der Wärmeverteilung bezüglich des Blechpakets 3 beiträgt.

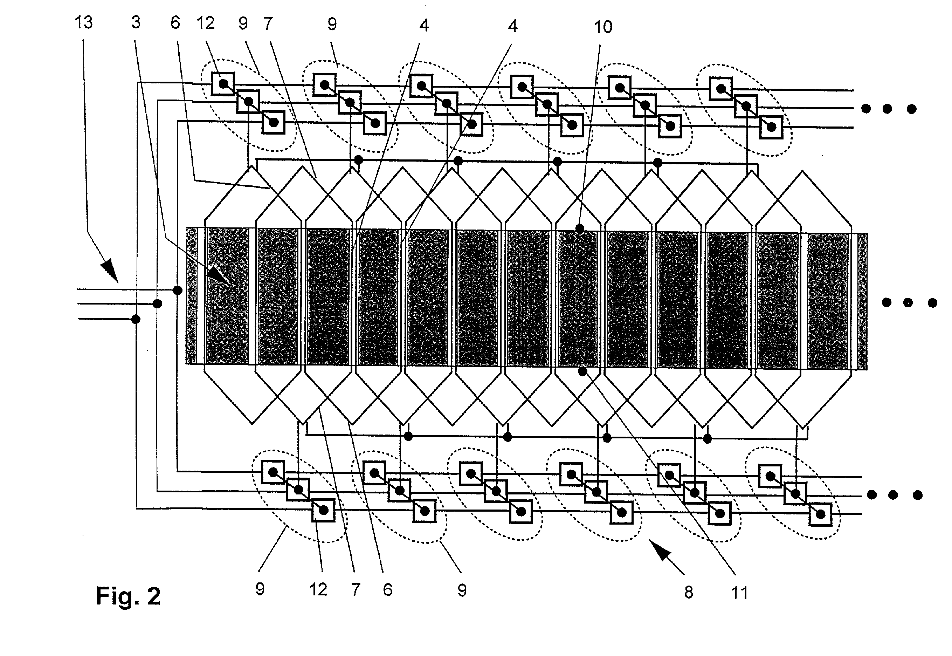

In Fig. 2 ist eine Darstellung in einer Ebene einer ersten Ausführungsform einer Wicklungsleiterverschaltung der erfindungsgemässen rotierenden elektrischen Maschine gezeigt. Wie bereits vorstehend erwähnt, sind die Wicklungsleiter 4 im Bereich der Stirnflächen 10, 11 zu ersten Wicklungsschleifen 6 und zweiten Wicklungsschleifen 7 verbunden. Gemäss der ersten Ausführungsform der Wicklungsleiterverschaltung nach Fig. 2 entspricht die Anzahl der Teilstromrichter 9 der Gesamtzahl der Wicklungsschleifen 6, 7, wobei die Wicklungsschleifen 6, 7 mit jeweils einem zugehörigen Teilstromrichter 9 verbunden sind. Dadurch kann der Stromfluss in jede Wicklungsschleife 6, 7 vorteilhaft separat beeinflusst werden, d.h. der Stromfluss in der entsprechenden Wicklungsschleife 6, 7 ist unabhängig von den restlichen Wicklungsschleifen 6, 7 zu jedem beliebigen Zeitpunkt und in gewünschter Richtung einstellbar. Beispielsweise lässt sich die Polpaarzahl der rotierenden elektrischen Maschine durch eine solche gezielte Beeinflussung des Stromflusses durch die Wicklungsschleifen 6, 7 ändern, ohne dass eine material-, bauteil-, und zeitaufwendige Beschaltungsänderung der Wicklungsschleifen 6, 7 durchgeführt werden muss. Desweiteren sind die Teilstromrichter 9 parallel geschaltet. Gemäss Fig. 2 sind die ersten Wicklungsschleifen 6 weiterhin im Bereich der ersten Stirnfläche 10 des Blechpakets 3 miteinander verbunden und die zweiten Wicklungsschleifen 7 im Bereich der zweiten Stirnfläche 11 des Blechpakets 3 miteinander verbunden. Darüber hinaus ist gemäss Fig. 2 eine der Anzahl der ersten Wicklungsschleifen 6 entsprechende Anzahl Teilstromrichter 9 mit den ersten Wicklungsschleifen 6 verbunden und an der ersten Stirnfläche 10 angeordnet. Ferner ist eine der Anzahl der zweiten Wicklungsschleifen 7 entsprechende Anzahl Teilstromrichter 9 mit den zweiten Wicklungsschleifen 7 verbunden und an der zweiten Stirnfläche 11 angeordnet. Durch die im Bereich der ersten Stirnfläche 10 miteinander verbundenen ersten Wicklungsschleifen 6 und durch die im Bereich der zweiten Stirnfläche 11 miteinander verbundenen zweiten Wicklungsschleifen 7 sowie durch die zu den Wicklungsschleifen 6, 7 gehörenden und an der ersten beziehungsweise an der zweiten Stirnfläche 10, 11 angeordneten Teilstromrichter 9 kann der Stator 2 sehr einfach, schnell und damit effizient realisiert und hergestellt werden, da der Stator 2, abgesehen von den Verbindungen der Wicklungsschleifen 6, 7 und den zugehörigen Teilstromrichtern 9 bezüglich der jeweiligen Stirnfläche 10, 11, an beiden Stirnflächen 10, 11 identisch aufgebaut ist.

Die Teilstromrichter 9 weisen nach Fig. 2 erfindungsgemäss mehrere ansteuerbare Schaltelemente 12 auf, wobei jeder Teilstromrichter 9 mit Phasen 13 eines Wechselspannungsnetzes verbunden ist und die Anzahl der Schaltelemente 12 eines jeden Teilstromrichters 9 der Anzahl der mit dem Teilstromrichter 9 verbundenen Phasen 13 entspricht. In Fig. 2 sind beispielhaft drei Phasen 13 dargestellt, so dass sich demnach drei Schaltelemente 12 eines jeden Teilstromrichters 9 ergeben. Dadurch kann neben dem bereits erwähnten Vorteil der separaten Beeinflussung des Stromflusses in jeder Wicklungsschleife 6, 7 zusätzlich jede Wicklungsschleife 6, 7 mit jeder Phase 13 des Wechselspannungsnetzes verbunden werden, so dass eine Matrixumrichterstruktur der Teilstromrichter 9 gebildet ist. Eine solche Struktur kommt vorteilhaft ohne gängigen und bezüglich der Baugrösse problematischen Energiezwischenspeicher, wie beispielsweise einen durch eine Induktivität gebildeten Gleichstromzwischenkreis, aus. Vorzugsweise ist jedes Schaltelement 12 der Teilstromrichter 9 der ersten Ausführungsform der Wicklungsleiterverschaltung gemäss Fig. 2 durch einen bidirektionalen ansteuerbaren Leistungshalbleiterschalter, wie beispielsweise einen Diac oder Triac, gebildet. Alternativ zu dem vorstehend genannten bidirektionalen ansteuerbaren Leistungshalbleiterschalter ist jedes Schaltelement 12 erfindungsgemäss durch zwei unidirektionale ansteuerbare Leistungshalbleiterschalter und zwei passive Leistungshalbleiterschalter gebildet. Ein solches Schaltelement ist beispielsweise durch zwei Thyristoren mit jeweils einer in Serie geschalteten Diode gebildet, wobei die beiden Serienschaltungen parallel geschaltet sind.

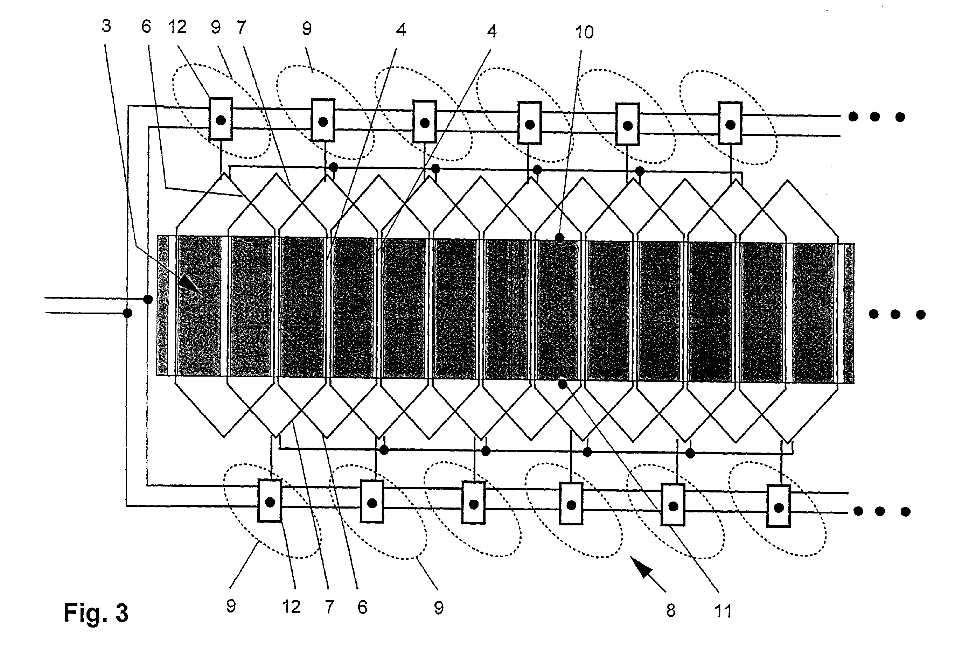

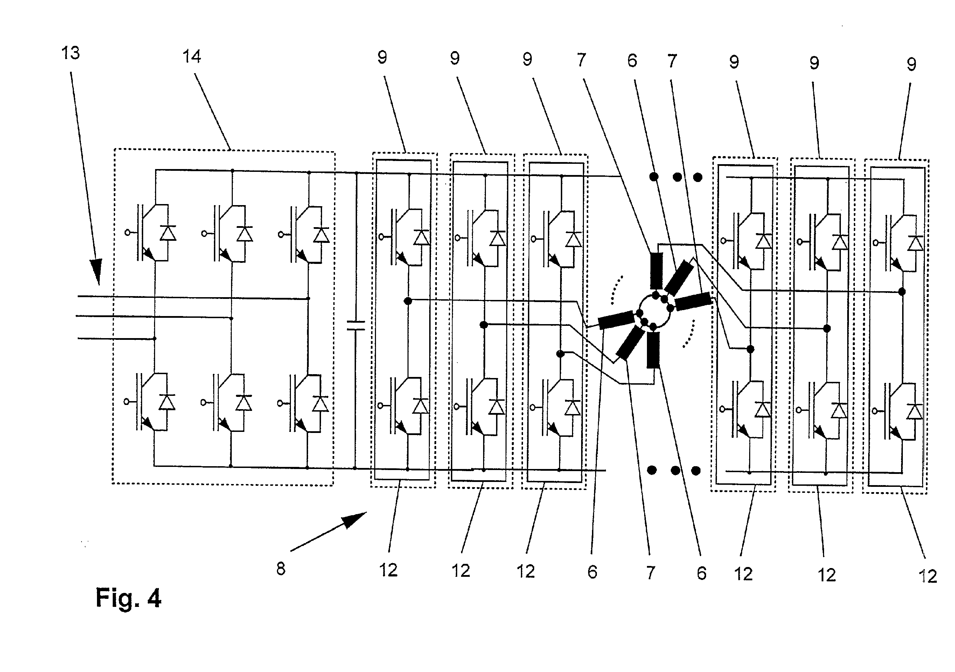

In Fig. 3 ist eine Darstellung in einer Ebene einer zweiten Ausführungsform einer Wicklungsleiterverschaltung der erfindungsgemässen rotierenden elektrischen Maschine gezeigt. Die zweite Ausführungsform der Wicklungsleiterverschaltung gemäss Fig. 3 unterscheidet sich von der vorstehend beschriebenen ersten Ausführungsform der Wicklungsleiterverschaltung gemäss Fig. 2 dahingehend, dass die Teilstromrichter 9 nach Fig. 3 erfindungsgemäss jeweils ein ansteuerbares Schaltelement 12 aufweisen, welches nach einer in Fig. 4 dargestellten Gesamtschaltung der erfindungsgemässen rotierenden elektrischen Maschine mit der zweiten Ausführungsform der Wicklungsleiterverschaltung gemäss Fig. 3 vorzugsweise durch zwei in Serie geschaltete unidirektionale ansteuerbare Leistungshalbleiterschalter mit jeweils einem antiparallel geschalteten passiven Leistungshalbleiterschalter gebildet ist. In Fig. 4 sind die unidirektionalen ansteuerbaren Leistungshalbleiterschalter beispielhaft als Bipolartransistoren mit jeweils isoliert angeordneter Ansteuerelektrode und die passiven Leistungshalbleiterschalter als Dioden realisiert. Im Unterschied zur ersten Ausführungsform der Wicklungsleiterverschaltung gemäss Fig. 2 sind bei der zweiten Ausführungsform der Wicklungsleiterverschaltung gemäss Fig. 3 zwar die Teilstromrichter 9 parallel geschaltet, jedoch ist nicht jeder Teilstromrichter 9 mit Phasen 13 eines Wechselspannungsnetzes verbunden. Vielmehr sind die Teilstromrichter 9 gemäss Fig. 4, insbesondere über einen Gleichspannungskondensator, mit der Gleichspannungsseite eines Wechselrichters 14 verbunden, wobei der Wechselrichter 14 vorzugsweise parallel zu mindestens einem Teilstromrichter 9 geschaltet ist. Darüber hinaus ist der Wechselrichter 14 gemäss Fig. 4 erfindungsgemäss mit den Phasen 13 eines Wechselspannungsnetzes verbunden und weist eine der Anzahl der Phasen 13 entsprechende Anzahl ansteuerbare und zueinander parallel geschaltete Schaltelemente 12 auf. Vorzugsweise sind die ansteuerbaren Schaltelemente 12 des Wechselrichters 14 jeweils durch zwei in Serie geschaltete unidirektionale ansteuerbare Leistungshalbleiterschalter mit jeweils einem antiparallel geschalteten passiven Leistungshalbleiterschalter gebildet, wobei die unidirektionalen ansteuerbaren Leistungshalbleiterschalter gemäss Fig. 4 beispielhaft als Bipolartransistoren mit jeweils isoliert angeordneter Ansteuerelektrode und die passiven Leistungshalbleiterschalter als Dioden realisiert sind. Vorteilhaft sind die ansteuerbaren Schaltelemente 12 des Wechselrichters 14 mit dem Blechpaket 3 thermisch kontaktiert, so dass die Kühlwirkung des Blechpakets 3 nicht nur, wie bereits vorstehend beschrieben, für den Stromrichter 8, sondern auch für die Schaltelemente 12 des Wechselrichters 14 ausgenutzt werden kann. Die ansteuerbaren Schaltelemente 12 des Wechselrichters 14 sind ferner an der sich in axialer Richtung bezüglich der Rotorachse 5 erstreckenden Mantelfläche 15 des Blechpakets 3 gemäss Fig. 1a und Fig. 1b angeordnet, wobei die Schaltelemente 12 des Wechselrichters 14 und deren thermische Kontaktierung und Anordnung auf dem Blechpaket 3 der Übersichtlichkeit halber nicht in Fig. 1a und Fig. 1b dargestellt sind. Die Anordnung der Schaltelemente 12 des Wechselrichters 14 auf der sich in axialer Richtung bezüglich der Rotorachse 5 erstreckenden Mantelfläche 15 bewirkt vorteilhaft, dass sich die Wärme der Schaltelemente 12 des Wechselrichters 14 homogen bezüglich des Blechpakets 3 verteilen kann und somit lokale Bereiche mit einer hohen Wärmedichte auf dem Blechpaket 3 vermieden werden können.

Mit der in Fig. 3 gezeigten zweiten Ausführungsform der Wicklungsleiterverschaltung beziehungsweise mit der in Fig. 4 dargestellten Gesamtschaltung ist der Stromfluss in jeder Wicklungsschleife 6, 7 ebenfalls wie mit der in Fig. 2 gezeigten und vorstehend beschriebenen ersten Ausführungsform der Wicklungsleiterverschaltung separat beeinflussbar, d.h. der Stromfluss in der entsprechenden Wicklungsschleife 6, 7 kann unabhängig von den restlichen Wicklungsschleifen 6, 7 zu jedem beliebigen Zeitpunkt und in gewünschter Richtung eingestellt werden. Gegenüber der ersten Ausführungsform der Wicklungsleiterverschaltung gemäss Fig. 2 kann mit der in Fig. 3 gezeigten zweiten Ausführungsform der Wicklungsleiterverschaltung beziehungsweise mit der in Fig. 4 dargestellten Gesamtschaltung die Gesamtzahl der Schaltelemente 12 deutlich verringert werden, so dass die in Fig. 3 gezeigte zweite Ausführungsform der Wicklungsleiterverschaltung beziehungsweise die in Fig. 4 dargestellte Gesamtschaltung eine besonders material- und bauteilextensive und damit eine sehr kostengünstig Lösung darstellt.

Die Anordnung der Schaltelemente 12 des Wechselrichters 14 auf der sich in axialer Richtung bezüglich der Rotorachse 5 erstreckenden Mantelfläche 15 bewirkt nur eine unwesentliche Vergrösserung des Umfangs und Durchmessers der rotierenden elektrischen Maschine, da die Anzahl der Schaltelemente gering ist und nur, wie vorstehend detailliert beschrieben, von der Anzahl der Phasen 13 des Wechselspannungsnetzes abhängt, so dass beispielsweise bei einem dreiphasigen Wechselspannungsnetz gemäss Fig. 4 lediglich drei Schaltelemente 12 benötigt werden. Demnach weist auch die rotierende elektrische Maschine nach der in Fig. 4 gezeigten Gesamtschaltung vorteilhaft eine gewünschte kleine Baugrösse auf.

Insgesamt kann mit der erfindungsgemässen rotierenden elektrischen Maschine eine gegenüber dem Stand der Technik verbesserte Kühlung des Stromrichters 8 der rotierenden elektrischen Maschine bei gleichzeitig geringer Baugrösse der rotierenden elektrischen Maschine erreicht werden, wobei zusätzlich ein besonders einfacher und damit kostengünstiger Aufbau realisierbar ist. Desweiteren ist die erfindungsgemässe rotierende elektrische Maschine durch die erfindungsgemässen Wicklungsleiterverschaltungen nach Fig. 2 und Fig. 3 besonders flexibel einsetzbar, d.h. in besonders einfacher Weise beispielsweise an verschiedenste Schaltungen und Antriebssysteme anpassbar, ohne dass aufwendige Änderungen in der Beschaltung der Wicklungsschleifen 6, 7 und der rotierenden elektrischen Maschine selbst notwendig sind.

### Bezugszeichenliste

- 1: Rotor
- 2: Stator
- 3: Blechpaket
- 4: Wicklungsleiter
- 5: Rotorachse
- 6: erste Wicklungsschleife
- 7: zweite Wicklungsschleife
- 8: Stromrichter
- 9: Teilstromrichter
- 10: erste Stirnfläche
- 11: zweite Stirnfläche
- 12: ansteuerbares Schaltelement
- 13: Phasen eines elektrischen Wechselspannungsnetzes
- 14: Wechselrichter
- 15: Mantelfläche

## Patentansprüche

1. Rotierende elektrische Maschine mit einem Rotor (1) und einem ein Blechpaket (3) aufweisenden Stator (2), welches von Wicklungsleitern (4) im wesentlichen axial bezüglich einer Rotorachse (5) durchzogen ist, wobei die Wicklungsleiter (4) im Bereich von Stirnflächen (10, 11) des Blechpakets (3) zu ersten Wicklungsschleifen (6) und zweiten Wicklungsschleifen (7) verbunden sind, und mit einem Stromrichter (8), der mit den Wicklungsschleifen (6, 7) verbunden ist,
**dadurch gekennzeichnet,**
**dass** der Stromrichter (8) aus Teilstromrichtern (9) mit jeweils mindestens einem ansteuerbaren Schaltelement (12) gebildet ist und die Teilstromrichter (9) mit dem Blechpaket (3) thermisch kontaktiert sind.

2. Rotierende elektrische Maschine nach Anspruch 1, **dadurch gekennzeichnet, dass** die Teilstromrichter (9) im Bereich mindestens einer Stirnfläche (10, 11) des Blechpakets (3) angeordnet sind.

3. Rotierende elektrische Maschine nach Anspruch 2, **dadurch gekennzeichnet, dass** die Teilstromrichter (9) ringförmig angeordnet sind.

4. Rotierende elektrische Maschine nach Anspruch 2 oder 3, **dadurch gekennzeichnet, dass** die Anzahl der Teilstromrichter (9) der Gesamtzahl der Wicklungsschleifen (6, 7) entspricht und die Wicklungsschleifen (6, 7) mit jeweils einem zugehörigen Teilstromrichter (9) verbunden sind.

5. Rotierende elektrische Maschine nach Anspruch 4, **dadurch gekennzeichnet, dass** die Teilstromrichter (9) parallel geschaltet sind.

6. Rotierende elektrische Maschine nach Anspruch 4 oder 5, **dadurch gekennzeichnet, dass** die ersten Wicklungsschleifen (6) im Bereich einer ersten Stirnfläche (10) des Blechpakets (3) miteinander verbunden sind, und dass die zweiten Wicklungsschleifen (7) im Bereich einer zweiten Stirnfläche (11) des Blechpakets (3) miteinander verbunden sind.

7. Rotierende elektrische Maschine nach Anspruch 6, **dadurch gekennzeichnet, dass** eine der Anzahl der ersten Wicklungsschleifen (6) entsprechende Anzahl Teilstromrichter (9) mit den ersten Wicklungsschleifen (6) verbunden ist und an der ersten Stirnfläche (10) angeordnet ist, und
dass eine der Anzahl der zweiten Wicklungsschleifen (7) entsprechende Anzahl Teilstromrichter (9) mit den zweiten Wicklungsschleifen (7) verbunden ist und an der zweiten Stirnfläche (11) angeordnet ist.

8. Rotierende elektrische Maschine nach Anspruch 7, **dadurch gekennzeichnet, dass** bei einem Teilstromrichter (9) mit mehreren ansteuerbaren Schaltelementen (12) jeder Teilstromrichter (9) mit Phasen (13) eines Wechselspannungsnetzes verbunden ist und die Anzahl der Schaltelemente (12) eines jeden Teilstromrichters (9) der Anzahl der mit dem Teilstromrichter (9) verbundenen Phasen (13) entspricht.

9. Rotierende elektrische Maschine nach Anspruch 8, **dadurch gekennzeichnet, dass** das Schaltelement (12) durch einen bidirektionalen ansteuerbaren Leistungshalbleiterschalter gebildet ist.

10. Rotierende elektrische Maschine nach Anspruch 8, **dadurch gekennzeichnet, dass** das Schaltelement (12) durch zwei unidirektionale ansteuerbare Leistungshalbleiterschalter und zwei passive Leistungshalbleiterschalter gebildet ist.

11. Rotierende elektrische Maschine nach Anspruch 7, **dadurch gekennzeichnet, dass** das ansteuerbare Schaltelement (12) bei einem Teilstromrichter (9) mit einem ansteuerbaren Schaltelement (12) durch zwei in Serie geschaltete unidirektionale ansteuerbare Leistungshalbleiterschalter mit jeweils einem antiparallel geschalteten passiven Leistungshalbleiterschalter gebildet ist.

12. Rotierende elektrische Maschine nach Anspruch 11, **dadurch gekennzeichnet, dass** ein Wechselrichter (14) parallel zu mindestens einem Teilstromrichter (9) geschaltet ist.

13. Rotierende elektrische Maschine nach Anspruch 12, **dadurch gekennzeichnet, dass** der Wechselrichter mit Phasen (13) eines Wechselspannungsnetzes verbunden ist und eine der Anzahl der Phasen (13) entsprechende Anzahl ansteuerbare und zueinander parallel geschaltete Schaltelemente (12) aufweist.

14. Rotierende elektrische Maschine nach Anspruch 13, **dadurch gekennzeichnet, dass** die ansteuerbaren Schaltelemente (12) des Wechselrichters (14) jeweils durch zwei in Serie geschaltete unidirektionale ansteuerbare Leistungshalbleiterschalter mit jeweils einem antiparallel geschalteten passiven Leistungshalbleiterschalter gebildet sind.

15. Rotierende elektrische Maschine nach Anspruch 13 oder 14, **dadurch gekennzeichnet, dass** die ansteuerbaren Schaltelemente (12) des Wechselrichters (14) mit dem Blechpaket (3) thermisch kontaktiert sind.

16. Rotierende elektrische Maschine nach Anspruch 15, **dadurch gekennzeichnet, dass** die ansteuerbaren Schaltelemente (12) des Wechselrichters (14) an einer sich in axialer Richtung bezüglich der Rotorachse (5) erstreckenden Mantelfläche (15) des Blechpakets (3) angeordnet sind.
